# EUROPEAN PATENT APPLICATION

(11) **EP 3 223 318 A1**
(43) Date of publication of application: **27.09.2017**
(21) Application number: 16161877.2
(22) Date of filing: 23.03.2016
(51) Int. Cl.: H01L 31/0224, H01L 31/0747

(54) **HETERO JUNCTION PHOTOVOLTAIC CELL AND METHOD OF MANUFACTURING SAME**

(71) Applicant: Meyer Burger (Germany) AG, 09337 Hohenstein-Ernstthal (DE)
(72) Inventor: Lachenal, Damien, 2016 Cortaillod (CH); Strahm, Benjamin, 1429 Giez (CH); Legradic, Boris, 1400 Yverdon-les Bains (CH); Frammelsberger, Walter, 2000 Neuchatel (CH)
(74) Representative: Steiniger, Carmen

(57) **Abstract**

The present invention relates to a hetero junction photovoltaic cell and to a method of manufacturing same, the photovoltaic cell comprising a crystalline semiconductor substrate of an n-type or a p-type, an amorphous intrinsic semiconductor layer formed on the full back side of the semiconductor substrate, an first type doped semiconductor layer structure formed locally on the amorphous intrinsic semiconductor layer, a second type doped semiconductor layer structure formed on the amorphous intrinsic semiconductor layer covering the first type doped semiconductor layer structure, and interdigitated nand p-type contacts for contacting the first and the second junction, respectively, on the back side of the photovoltaic cell. In the photovoltaic cell, the second type doped semiconductor layer structure covers the first type doped semiconductor layer structure in the region of the first junction, wherein a recombination layer structure is formed between the first type doped semiconductor layer structure and the second type doped layer structure and the contact for contacting the first junction is formed on the layer stack comprising the first type doped semiconductor layer structure, the recombination layer structure and the second type doped semiconductor layer structure.

## Description

The present invention relates to a hetero junction photovoltaic cell having a front side for light incidence and a back side opposite to the front side, a crystalline semiconductor substrate of an n-type or a p-type, an amorphous intrinsic semiconductor layer formed on the full back side of the semiconductor substrate, a first type doped semiconductor layer structure formed locally on the amorphous intrinsic semiconductor layer, whereby forming a first junction with the semiconductor substrate, a second type doped semiconductor layer structure, opposite to the type of doping of the first type doped semiconductor layer, formed on the amorphous intrinsic semiconductor layer covering the first type doped semiconductor layer structure, whereby forming a second junction with the semiconductor substrate, and interdigitated n- and p-type contacts for contacting the first and the second junction, respectively, on the back side of the photovoltaic cell.

The invention further relates to a method of manufacturing a photovoltaic cell with a front side for light incidence and a back side opposite to the front side, comprising the steps of providing a crystalline semiconductor substrate of an n-type or a p-type, forming an amorphous intrinsic semiconductor layer on the full rear surface of the semiconductor substrate, forming a first type doped semiconductor layer structure locally on the amorphous intrinsic semiconductor layer, whereby forming a first junction with the semiconductor substrate, forming a second type doped semiconductor layer structure on the amorphous intrinsic semiconductor layer, whereby forming a second junction with the semiconductor substrate besides the first junction, and forming interdigitated p- and n-type contacts contacting the first and the second junction, respectively, on the back side of the photovoltaic cell.

A photovoltaic cell of the above mentioned type and a method for producing therefore are disclosed in the paper of Lachenal et al: "Interdigitated back contact design combined with silicon heterojunction technology: A promising candidate for very high efficiency industrial solar cells.", published in the proceedings of the 29th European Photovoltaic Solar Energy Conference and Exhibition, June 22 to 26, 2016. Said paper suggests a photovoltaic cell including both an interdigitated back contact (IBC) and a hetero junction (HJT) structure. In comparison to standard solar cells with a front grid, photovoltaic cells with interdigitated back contact show very high current densities. On the other hand, the hetero junction technology enables very high open-circuit voltages.

The known process flow for producing IBC-HJT photovoltaic cells includes the following steps: After texturing and cleaning, an n-type wafer is passivated on the front side with a stack of intrinsic and n-doped amorphous silicon layers. On the back side, the surface passivation is realized using again an intrinsic amorphous silicon layer. Moreover, locally separated n- and p-doped amorphous layers are deposited on the back side intrinsic layer via a masking technique. Following this, a stack of TCO (transparent conductive oxide) and metal is deposited on the back side of the doped layers while the front side receives a silicon nitride layer as anti-reflective coating. The final metal opening for the definition of the back sided n- and p-contacts is made, first by depositing a patterned ink on the back side of the cell, and finally by metal contact separation using wet etching and ink removal.

This process uses alignment and structuring processes developed for either integrated circuits or thin film technology. These processes include lithographic steps or multiple mechanical masking steps with the necessity of precise alignment which makes processing costly with the risk of low yield.

In order to prevent recombination of carriers on the back side of a solar cell, the document US 2012/0052622 A1 suggests another type of back contact solar cell. After local formation of stacks of i-type amorphous and p-type amorphous semiconductor layer islands, a recombination layer is formed on the p-type amorphous semiconductor layer. The recombination layer may be formed of a semiconductor material in which a large number of in-gap states existing in an energy band exist, or of a metal material that forms an ohmic contact with the p-type amorphous semiconductor layer. Then, an intrinsic amorphous semiconductor layer and an n-type amorphous semiconductor layer are deposited on the whole back surface, followed by formation of spaced p-side and n-side electrodes. The recombination layer being inserted shall reduce the resistance between the p-type amorphous semiconductor layer and the p-side electrodes.

Another type of solar cell is known from the document EP 1 519 422 A2. Said solar cell comprises a back side on which a layer stack consisting of an i-type amorphous silicon film, a p-type amorphous silicon film, a back electrode of TCO and a collector electrode of silver is formed locally, followed by a full back side deposition of an i-type amorphous silicon film and an n-type amorphous silicon film. Since the i-type amorphous silicon film and the n-type amorphous silicon film are formed without the use of a metal mask, manufacturing cost and time can be reduced. Thereafter, a negative electrode consisting of a back electrode of TCO and a collector electrode of silver is formed locally on the part of the back surface where no p-type amorphous silicon is present. Since the thicknesses of the i-type amorphous silicon film and the n-type amorphous silicon film are very small, the collector electrode of the positive electrode shall be electrically connected by jointing wiring or the like to the n-type amorphous silicon film on said collector electrode, to say, the back electrode and the collector electrode of the positive electrode are electrically connected through the intrinsic and the n-type amorphous silicon films.

It is the object of the present invention to provide a photovoltaic cell and a method for producing same which includes both the advantages of IBC and HJT solar cells and is, nevertheless, at low cost producible.

The object is solved by a hetero junction photovoltaic cell of the above mentioned type, wherein the second type doped semiconductor layer structure covers the first type doped semiconductor layer structure in the region of the first junction, wherein a recombination layer structure is formed between the first type doped semiconductor layer structure and the second-type doped semiconductor layer structure and the contact for contacting the first junction is formed on the layer stack comprising the first type doped semiconductor layer structure, the recombination layer structure and the second type doped semiconductor layer structure.

Preferably, at least one outer transparent conductive oxide layer is provided locally between the second type doped layer structure and the interdigitated p- and n-type contacts.

In the hetero junction photovoltaic cell of the present invention, both junctions, to say the emitter, i. e. p-type emitter on an n-type semiconductor substrate, and the back surface field junction, i. e. an n-type back surface field on an n-type semiconductor substrate, are on the back side of the photovoltaic cell, wherein one junction type covers the other junction type underneath with the recombination layer structure in between. The recombination layer structure can be of at least one transparent conductive oxide (TCO) layer, covered or non-covered by at least one metal layer. The photovoltaic cell of the present invention can therefore be produced at low cost in the cell process flow. In this process flow, no alignment is required to pattern both the p- and n-junctions. In particular, any patterning of the second type doped semiconductor layer structure above the first junction comprising the first type doped semiconductor layer structure is avoided. Despite of the formation of the second type doped layer structure above the first type doped semiconductor layer structure, said first type doped semiconductor layer structure can be smoothly electrically contacted via the second type doped semiconductor layer structure and the intermediate recombination layer structure. This is possible due to the natural low conductivity of the doped semiconductor layer structure, wherein for example an amorphous p-doped layer such as an a-Si:H(p) layer of said second type doped semiconductor layer structure does not conduct laterally the carriers and therefore prevents shunting of the two separated p- and n-contacts. The second type doped semiconductor layer structure lying on the first type doped semiconductor layer structure forming for instance the back surface field of the photovoltaic cell, does not make any transport losses. Furthermore, there is no resistance loss, especially no contact resistance loss on the back surface field side of the photovoltaic cell, by adding the second type doped semiconductor layer structure between the recombination layer structure provided on top of the first type doped semiconductor layer structure and the outer transparent conductive oxide layer being part of the contact of the solar cell. The second type doped semiconductor layer structure is in this area, for instance between a ZnO layer as first transparent conductive oxide layer structure and an ITO layer as outer transparent conductive oxide layer structure, wherein both TCO layers can be capped with a metal layer.

The thickness of the second type doped semiconductor layer structure, measured on flat surface, can be in the range of 5 to 50 nm. For example, the specific resistivity of a p-type layer structure is typically in the range of 1 x 10⁻⁵ to 1 x 10⁻⁷ S/cm. The p-type layer structure is characterized by a very high sheet resistance in the range of about 10⁹ to about 10¹² Ω/squire (horizontal conduction) while the layer thickness of about 5 to 50 nm does not limit the vertical conduction of the carriers. Thus, this asymmetric resistivity behavior allows getting separated n- and p-contacts without specifically patterning the second type doped semiconductor layer structure. Photovoltaic cells having the inventive structure have shown a shunt resistance up to 1.8 MΩ x cm².

The hetero junction photovoltaic cell of the present invention is a "sandwich"-cell having a lot of benefits in comparison to the state of the art: The photovoltaic cell can be produced using a single mask solution. The photovoltaic cell of the present invention has self-aligned n-p regions. The photovoltaic cell of the present invention includes a full second type doped coverage with no tails allowing a large back metallization of the cell. The using of first and second transparent conductive oxide layer structures for the recombination layer structure and for the outer transparent conductive oxide layer, respectively, offers the possibility to tune the TCO structures independently for each contact. In the technology for manufacturing of the photovoltaic cell of the present invention, no expensive alignment is needed at PECVD. Furthermore, a "bifacial cell"-IBC structure can be realized with the photovoltaic cell of the present invention.

In comparison to the solar cell of the document EP 1 519 422 A2, the first deposited amorphous intrinsic semiconductor layer of the photovoltaic cell of the present invention is formed on the full back side of the semiconductor substrate, whereas the said first intrinsic semiconductor layer is deposited locally on the rear side of the solar cell of EP 1 519 422 A2. That has the advantage that the surface of the back side of the photovoltaic cell of the present invention is already protected by the amorphous intrinsic semiconductor layer before depositing a mechanical mask for a local formation of the first type doped layer structure. Moreover, in the present invention, a second intrinsic semiconductor layer as deposited in EP 1 519 422 A2 on the full surface is not necessary. That leads to a higher fill factor of the photovoltaic cell of the present invention due to lower resistive losses on top of the first type doped layer structure.

In further contrast to the solar cell of the document EP 1 519 422 A2, for manufacturing of the photovoltaic cell of the present invention the outer transparent conductive oxide layer is deposited as contact layer on the full back side surface and later separated to the different doping types of the interdigitated p- and n-type contacts. This establishes a good contact with the localized interdigitated p- and n-type contacts. For example, contact structures made with the help of printed silver contacts will profit of a full surface deposited contact layer whereas it might give a bad contact to an amorphous layer as suggested in EP 1 519 422 A2.
In embodiments of the present invention, the second type doped semiconductor layer structure can comprise a second amorphous intrinsic semiconductor layer and an amorphous and/or multi-crystalline p-type doped semiconductor layer.

The object is further solved by a method of the above mentioned type wherein a recombination layer is locally formed on the first type doped semiconductor layer structure, and the second type doped semiconductor layer structure is formed above the first type doped semiconductor layer structure and a recombination layer structure, realized for example by a first transparent conductive oxide layer, and the contact for contacting the first junction is formed on the layer stack comprising the first type doped semiconductor layer structure, the recombination layer and the second type doped semiconductor layer structure.

It has been found in the present invention that it is not necessary to remove or partially open the second type doped layer structure deposited on top of the first type doped semiconductor layer structure and the recombination layer structure, to get a high fill factor and efficiency of the resulting photovoltaic cell. This finding enables a simplified processing sequence without detrimental effects.

The process sequence according to the method of the present invention includes a reduced number of alignment steps in comparison to the state of the art and gives thereby the potential of higher yield and lower costs. The method of the present invention implies a self-alignment process for the structuring of the n- and p-doped hetero junctions of the photovoltaic cell without the need of adjusting multiple masks in this process.

Preferably, the first localized doped semiconductor layer structure and the localized recombination layer structure are formed by using the same mechanical mask.

In this embodiment, it is further preferred if the mechanical mask is not removed in between the two deposition steps of the first localized doped semiconductor layer structure and the localized recombination layer structure.

According to a first possibility to form the metallization of the photovoltaic cell of the present invention, the forming of the interdigitated p- and n-type contacts comprising the steps of: depositing at least one outer transparent conductive oxide layer on the full second type doped semiconductor layer structure, forming a mask of resist on the outer transparent conductive oxide layer covering only later contact areas of the interdigitated p- and n-type contacts being separated from each other, etching back chemically the outer transparent conductive oxide layer in the non-covered areas, stripping the mask of resist, and forming contact fingers on the structured transparent conductive oxide layer.

In another variant for forming the metallization of the photovoltaic cell of the present invention, the forming of the interdigitated p- and n-type contacts comprising the steps of: forming a mask of resist on the second type doped semiconductor layer structure covering only the separated later non-contact areas of the interdigitated p- and n-type contacts, depositing at least one outer transparent conductive oxide layer on the masked second type doped semiconductor layer structure by covering the resist, lifting off the resist by leaving localized structures of the material of the transparent conductive oxide layer structure, and forming contact fingers on the structured outer transparent conductive oxide layer structure.

In a yet further embodiment of producing the photovoltaic cell of the present invention, the forming of the interdigitated p- and n-type contacts comprising the steps of: depositing at least one outer transparent conductive oxide layer on the full second type doped semiconductor layer structure, depositing a seed metal layer on the full outer transparent conductive oxide layer structure, forming a mask of resist on the metal seed layer covering only the separated later non-contact areas of the interdigitated p- and n-type contacts, forming contact fingers by depositing metal in the regions being free of resist by electrochemical plating, stripping the resist, and etching back chemically the material of the outer transparent conductive oxide layer between the contact fingers.

The contact between the recombination layer structures, for example a first TCO layer, and the outer transparent conductive oxide layer structures being on top of the first type doped semiconductor layer structure can be improved if the step of forming the interdigitated p- and n-type contacts comprises further the step of: melting the material of the at least one first and the outer transparent conductive oxide layer through the intermediate second type semiconductor doped layer structure by laser scribing.

Preferred embodiments of the present invention are shown in the figures, wherein in all figures the back side is up and the front side is down, wherein
- Fig. 1: schematically shows a side elevation of a semiconductor substrate being passivated at its front and back side,
- Fig. 2: schematically shows a side elevation of a semiconductor substrate being passivated at its front and back side with another variant of front side passivation as in Fig. 1;
- Fig. 3: schematically shows the structure of Fig. 1 having on its back side localized amorphous n-type layer structures being covered by a first transparent conductive oxide material;
- Fig. 4: schematically shows the structure of Fig. 3 being fully covered on its back side with an amorphous p-type layer structure;
- Fig. 5: schematically shows the structure of Fig. 4 being fully covered on its back side with a second transparent conductive oxide layer and having on said transparent conductive oxide layer localized resist patterns in accordance with a first metallization scheme;
- Fig. 6: schematically shows the structure of Fig. 5 after wet etching of the non-covered second transparent conductive oxide layer and screen printing of a final metallization resulting in a first embodiment of a photovoltaic cell of the present invention;
- Fig.7: schematically shows the structure of Fig. 4 after locally printing of resist followed by a full area deposition of a second transparent conductive oxide material in accordance with a second metallization scheme;
- Fig. 8: schematically shows the structure of Fig. 7 after stripping of the resist;
- Fig. 9: schematically shows the structure of Fig. 8 after locally printing of a final metallization resulting in a second embodiment of a photovoltaic cell of the present invention;
- Fig. 10: schematically shows the structure of Fig. 4 after full area deposition of an outer transparent conductive oxide layer and a seed metal layer and locally printing of resist in accordance with a third metallization scheme;
- Fig. 11: schematically shows the structure of Fig. 10 after plating of metal on the non-covered metal seed layer areas;
- Fig. 12: schematically shows the structure of Fig. 11 after stripping of the resist resulting in a third embodiment of a photovoltaic cell of the present invention; and
- Fig. 13: schematically shows a photovoltaic structure of an embodiment of the present invention, wherein the contact between the first and the second transparent conductive oxide layer structures is ameliorated by laser treatment.

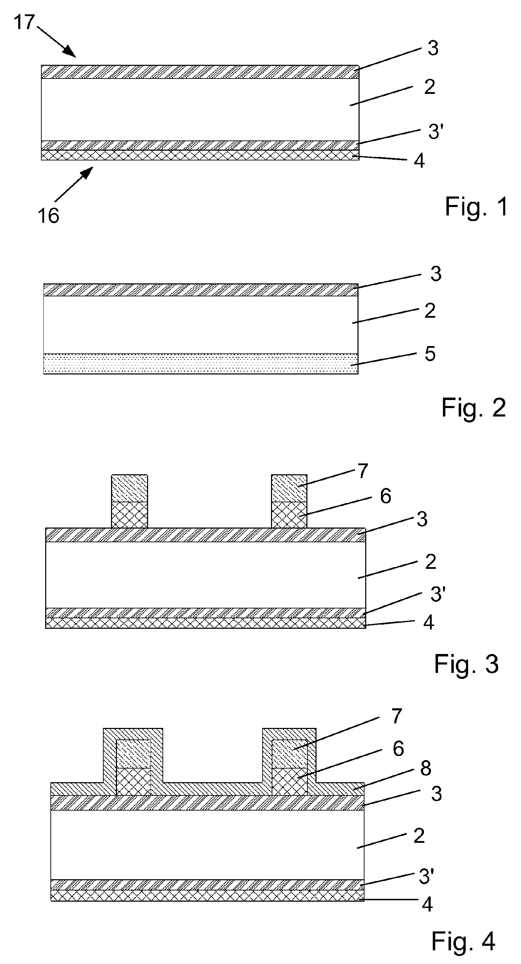

Fig. 1 schematically shows a side elevation of a semiconductor substrate 2. The semiconductor substrate 2 is in the embodiment shown a crystalline silicon substrate of n-type, to say with n-type doping. In other not shown embodiments of the present invention, the semiconductor substrate 2 can also be of another semiconductor material and/or can have another type of crystallinity and/or can be of p-type.

The semiconductor substrate 2 is coated on its front side 16 which is the light incident side, and on its back side 17, being opposite the front side 16.

The front side 16 is coated with at least one passivating layer and an anti-reflective coating. Said layer stack can include at least one SiN layer and/or can include a stack of an intrinsic amorphous layer plus optionally a doped amorphous layer wherein the latter is covered by an anti-reflective coating (ARC) based on a transparent conductive oxide (TCO) or a dielectric layer like SiN, SiOₓN, AlOₓ or a similar material and/or can include an intrinsic amorphous silicon oxide nitride passivating layer (a-SiON:H) covered by a dielectric SiN anti reflective coating. In the embodiment shown in Fig. 1, the front side 16 is passivated with at least one amorphous intrinsic Si:H- or SiONₓ-layer 3'. Optionally, at least one amorphous n-doped Si:H-layer 4 is deposited on the amorphous intrinsic Si:H- or SiONₓ-layer 3'.

In another variant of the present invention, shown in Fig. 2, the front side 16 of the semiconductor substrate 2 is covered with at least one SiNₓ- and/or Al₂O₃- and/or another anti reflective coating layer 5.

In still another variant of the invention the ARC can be a layer stack made out of the same or different types of materials, to adjust the refractive index between the silicon wafer and the encapsulation material used when integrating later the finished solar cell into an encapsulated solar module for reduced reflectivity at its interface.

The semiconductor substrate 2 is coated on its back side 17 with at least one amorphous intrinsic layer 3, such as an amorphous intrinsic Si:H layer. The intrinsic amorphous layer 3 is deposited on the full rear surface of the semiconductor substrate 2. The amorphous intrinsic layers 3, 3' can be deposited in one step on both sides of the semiconductor substrate 2.

In the further description we show one variant of how to choose first and second type doped layers. In the example we are using an n-type layer for the first type doping and a p-type layer for the second type doping.

As shown in Fig. 3, the deposition of the intrinsic layer 3, on the full surface of the substrate on the side opposite to the light incident side, is followed by forming of a first type doped semiconductor layer structure which is in the example shown a localized amorphous n-type layer structure 6, to say a structure of at least one layer with an n-doping. In other non-shown embodiments of the present invention, the n-type layer structure 6 can also be a multi-crystalline layer structure. In further examples of the present invention, the first type doped semiconductor layer structure can also be of p-type.

The locally formed islands of the n-doped layer structure 6 can be formed through a mechanical mask such as a shadow mask on the back side 17 of the shown cell structure. The n-type layer structure 6 forms with the material of the semiconductor substrate 2 a first junction, which is an n-n junction in the cell structure shown in Fig. 3. The n-type layer structure 6 can be for instance an amorphous or multi-crystalline Si:H-based layer.

The same mask is then used to deposit locally a recombination layer structure, for example one first transparent conductive oxide (TCO) layer 7 structure, which is shown in Fig. 3. Another example for the recombination layer structure could be at least one metal layer or a stack of a first transparent conductive oxide layer structure and a metal layer structure 7. The transparent conductive oxide layer structure can be, for example, made of ZnO (zinc oxide) or ITO (indium tin oxide). The metal layer can be made of Ag (silver), CU (copper), Al (aluminum) and/or Ni (nickel). The transparent conductive oxide layer structure and/or the metal layer can be, exemplarily, deposited by PVD (physical vapor deposition).

After the localized deposition of the recombination layer structure 7, a second type doped semiconductor layer structure, which is in the example shown a p-type layer structure 8, is deposited on the full surface of the back side 17 of the cell structure, as shown in Fig. 4. The p-type layer structure 8 covers the amorphous intrinsic layer 3, the n-type layer structure 6 as well as the recombination layer structure 7 and comprises at least one p-doped amorphous and/or multi-crystalline layer. The p-type layer structure 8 forms with the material of the semiconductor substrate 2 a second junction, which is a p-n junction in the cell structure shown in Fig. 4. That is, the cell structure shown in Fig. 4 forms the basis of the hetero junction structure of the photovoltaic cell to produce. In other embodiments of the invention in which the first type doped semiconductor layer structure 6 is of p-type, the second type doped semiconductor layer structure 8 is of n-type.

In a next step, the hetero junctions are contacted and reinforced with conductive structures like a TCO metal stack or a TCO conductive print stack. For the contacting exist different ways, some of them are explained in detail below.

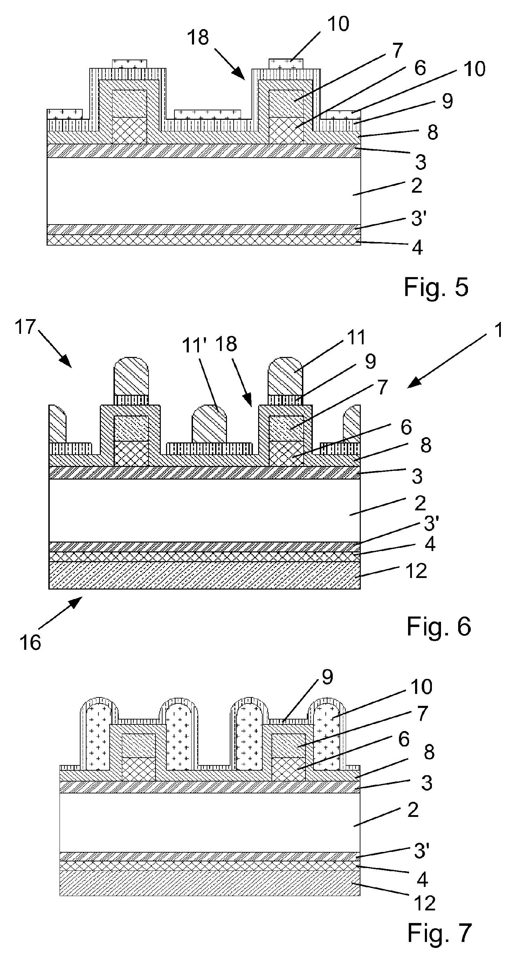

According to a first metallization scheme, shown in Figs. 5 and 6, an outer transparent conductive oxide layer structure 9 is deposited on the full surface of the back side 17 of the cell structure hereby covering the p-type layer structure 8. The outer transparent conductive oxide layer structure 9 can be of ZnO or ITO, for example.

In a further step, a mask of resist 10 is deposited on the full surface of the back side 17 of the cell structure. The design of the mask has to be aligned in this step to the design of the first, locally deposited transparent conductive oxide layer structure 7. The mask of the resist 10 covers the later contact areas of both, the p- and the n-type contact 11, 11' of the photovoltaic cell 1 shown in Fig. 6 and leaves free areas 18 that separate the p- and n-contacts 11, 11' from each other. The mask of resist 10 can be printed for example by screen printing, inkjet printing or another high resolution printing process.

In a following process step, the non-covered areas of the outer transparent conductive oxide layer structure 9 are etched back in a chemical bath. In the case of ZnO as second transparent conductive oxide layer structure 9, this can be done for example in a diluted HCl solution or in acetic acid.

Then, the previously printed mask of resist 10 is stripped in a suited chemical solution.

In a final step, the contact areas being based of the outer transparent conductive oxide layer structure 9 are reinforced with printed contact 11, 11' fingers to reduce potential Ohmic losses within the contact structures of the material of the outer transparent conductive oxide layer structure 9. The finger printing process has to be aligned again to the structure of the contact areas originally defined by the deposition of the recombination layer structure 7. The resulting photovoltaic cell 1 is shown in Fig. 6.

Figs. 7 to 9 show a second metallization scheme for the cell structure of Fig. 4. As shown in Fig. 7, a resist 10 type mask is deposited first locally for instance by screen printing or another adequate printing process on the back side 17 of the cell structure of Fig. 4. This printing process has to be aligned with the pattern of the recombination layer structure 7.

In a following step, the outer transparent conductive oxide layer structure 9 or alternatively a stack consisting of the outer transparent conductive oxide layer structure 9 and at least one metal layer is deposited on the full surface of the cell structure, covering the resist 10 and resulting in the cell structure shown in Fig. 7.

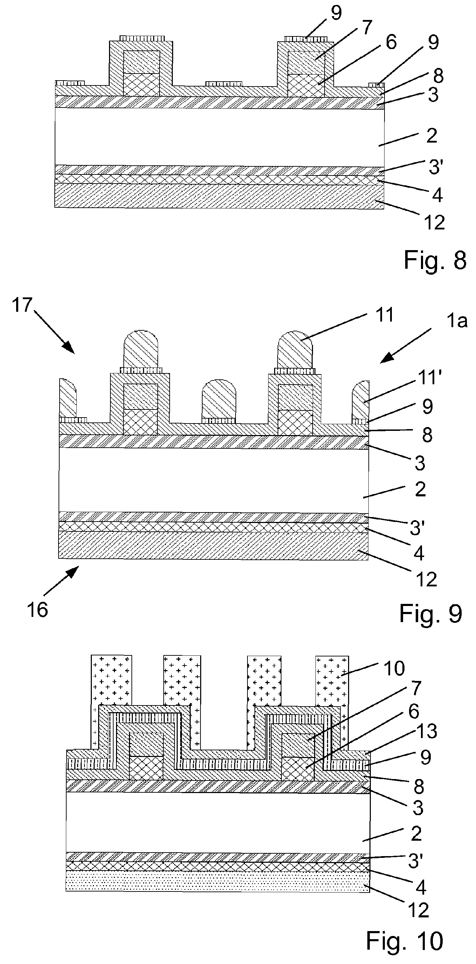

Thereafter, the resist 10 is lifted off leaving localized structures of the material of the outer transparent conductive oxide layer structure 9, as shown in Fig. 8.

In an additional step, these localized TCO structures 9 are reinforced with printed contact 11, 11' fingers. The contact 11, 11' fingers can be made of a silver paste. This printing process again has to be aligned to the pattern of the contact areas defined by the pattern of the recombination layer structure 7. The resulting photovoltaic cell 1 a is shown in Fig. 9.

In Figs. 10 to 12, a third metallization scheme for the cell structure Fig. 4 is demonstrated. As shown in Fig. 10, a layer sequence consisting of an outer transparent conductive oxide layer structure 9 and at least one seed metal layer 13 is deposited on the full surface of the cell structure of Fig. 4.

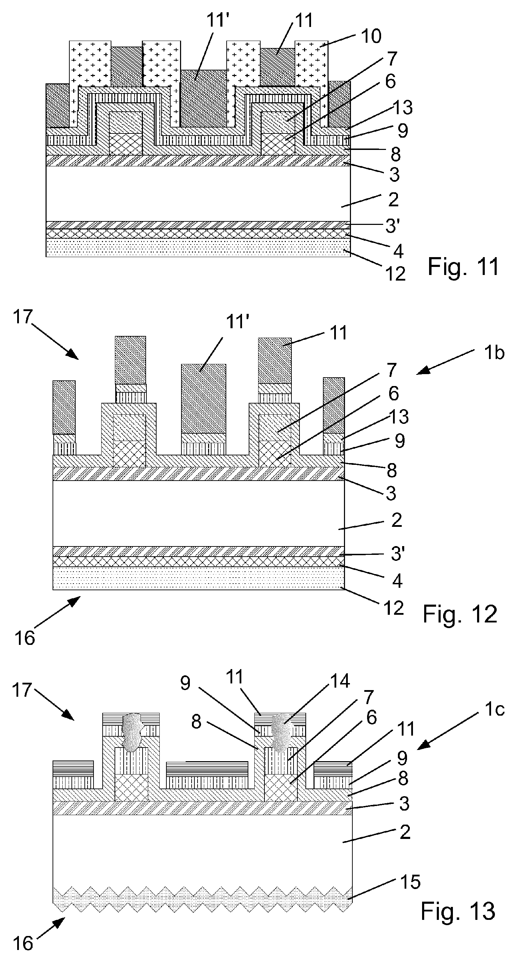

Then, a resist 10 is printed locally on the back side 17 of the cell structure resulting in the cell structure shown in Fig. 10. Said mask of resist 10 defines the position of the later electrical contacts 11, 11' shown in Fig. 12. The print of the resist 10 is aligned to the hetero junction contacts.

In a further step shown in Fig. 11, the areas being not coated with the resist 10 are reinforced in an electrochemical plating step by depositing for example at least one Ag, Cu, Al, Ni and/or Cr layer. It can be also advantageous to use a multilayer stack of at least two of the mentioned metals to improve adhesion to the underlying outer transparent conductive oxide layer structure 9 or to give a more stable contact against environmental stress.

As shown in Fig 12, the resist 10 is finally stripped off and the outer transparent conductive oxide layer structure 9 is chemically etched back between the hetero junction contacts 11, 11' resulting in a photovoltaic cell 1 b.

Even if tests have shown that a good contact between the n-type layer structure 6 and the outer contact 11 can be provided through the p-type layer structure 8 there between with the help of the intermediate outer transparent conductive oxide layer structure 9 or a TCO metal layer stack, an additional step can improve said contact further. As shown in Fig. 13, the additional step is done by at least partially melting a contact region 14 between the recombination layer structure 7 and the outer transparent conductive oxide layer structures 9 through the p-type layer structure 8 by a laser scribe in this region 14. The laser parameters should be adjusted to just melt the recombination layer structure 7 and the outer transparent conductive oxide layer structure 9 without removing them and without damaging the below situated n-type layer structure 6. The resulting photovoltaic cell 1c is shown in Fig. 13. Layer structure 15 in Fig. 13 symbolizes one of the above mentioned layer structures on the light incident side consisting of a passivating layer structure and an anti-reflective layer structure. Fig. 13 also shows in a symbolic form that the different described solar cells can be textured on at least one side.

## Claims

1. Hetero junction photovoltaic cell (1, 1 a, 1 b, 1 c) having
a front side (16) for light incidence and a back side (17) opposite to the front side (16),
a crystalline semiconductor substrate (2) of an n-type or a p-type,
an amorphous intrinsic semiconductor layer (3) formed on the full back side (17) of the semiconductor substrate (2),
a first type doped semiconductor layer structure (6) formed locally on the amorphous intrinsic semiconductor layer (3), whereby forming a first junction with the semiconductor substrate (2),
a second type doped semiconductor layer structure (8), opposite to the type of doping of the first type doped semiconductor layer structure (6), formed on the amorphous intrinsic semiconductor layer (3) covering the first type doped semiconductor layer structure (6), whereby forming a second junction with the semiconductor substrate (2) besides the first junction, and
interdigitated n- and p-type contacts (11, 11') for contacting the first and the second junction, respectively, on the back side (17) of the photovoltaic cell (1, 1 a, 1 b, 1 c), **characterized in that**
the second type doped semiconductor layer structure (8) covers the first type doped semiconductor layer structure (6) in the region of the first junction, wherein a recombination layer structure (7) is formed between the first type doped semiconductor layer structure (6) and the second type doped semiconductor layer structure (8) and the contact (11) for contacting the first junction is formed on the layer stack comprising the first type doped semiconductor layer structure (6), the recombination layer structure (7) and the second type doped semiconductor layer structure (8).

2. Photovoltaic cell of at least one the preceding claims, **characterized in that** the recombination layer structure (7) is made out of at least one first transparent conductive oxide layer being capped or non-capped by at least one metal layer, or is made out of a metal layer or metal layer stack.

3. Photovoltaic cell of at least one the preceding claims, **characterized in that** at least one outer transparent conductive oxide layer (9) is provided locally between the second type doped semiconductor layer structure (8) and the interdigitated n- and p-type contacts (11, 11').

4. Method of manufacturing a photovoltaic cell (1, 1 a, 1 b, 1 c) with a front side (16) for light incidence and a back side (17) opposite to the front side (16), comprising the steps of
providing a crystalline semiconductor substrate (2) of a n-type or a p-type,
forming an amorphous intrinsic semiconductor layer (3) on the full back side (17) of the semiconductor substrate (2),
forming a first type doped semiconductor layer structure (6) locally on the amorphous intrinsic semiconductor layer (3), whereby forming a first junction with the semiconductor substrate (2),
forming a second type doped semiconductor layer structure (8) on the amorphous intrinsic semiconductor layer (3) covering the second type doped semiconductor layer structure (6), whereby forming a second junction with the semiconductor substrate (2), and
forming interdigitated n- and p-type contacts (11, 11') contacting the first and the second junction, respectively, on the back side (17) of the photovoltaic cell (1, 1 a, 1b, 1c),
**characterized in that**
a recombination layer structure (7) is locally formed on the first type doped semiconductor layer structure (6), and the second type doped semiconductor layer structure (8) is formed above the first type semiconductor doped layer structure (6) and the recombination layer structure (7), and
the contact (11) for contacting the first junction is formed on the layer stack comprising the first type doped layer structure (6), the recombination layer structure (7) and the second type doped semiconductor layer structure (8).

5. Method of claim 4, **characterized in that** the first localized doped semiconductor layer structure (6) and the localized recombination layer structure (7) are formed by using the same mechanical mask.

6. Method of claim 5, **characterized in that** the mechanical mask is not removed in between the two deposition steps of the first localized doped semiconductor layer structure (6) and the localized recombination layer structure (7).

7. Method of claim 4, **characterized in that** the forming of the interdigitated n- and p-type contacts (11, 11') comprising the steps of:
depositing at least one outer transparent conductive oxide layer (9) on the full second type doped semiconductor layer structure (8),
forming a mask of resist (10) on the outer transparent conductive oxide layer (9) covering only later contact areas of the interdigitated n- and p-type contacts (11, 11') being separated from each other,
etching back chemically the outer transparent conductive oxide layer (9) in the non-covered areas,
stripping the mask of resist (10), and
forming contact (11, 11') fingers on the structured outer transparent conductive oxide layer structure (9).

8. Method of claim 4, **characterized in that** the forming of the interdigitated n- and p-type contacts (11, 11') comprising the steps of:
forming a mask of resist (10) on the second type doped semiconductor layer structure (8) covering only the separated later non-contact areas of the interdigitated n-and p-type contacts (11, 11'),
depositing at least one outer transparent conductive oxide layer (9) on the masked second type doped semiconductor layer structure (8) by covering the resist (10),
lifting off the resist (10) by leaving localized structures of the material of the outer transparent conductive oxide layer structure (9), and
forming contact (11, 11') fingers on the structured outer transparent conductive oxide layer structure (9).

9. Method of claim 4, **characterized in that** the forming of the interdigitated n- and p-type contacts (11, 11') comprising the steps of:
depositing at least one outer transparent conductive oxide layer (9) on the full second type doped semiconductor layer structure (8),
depositing a seed metal layer (13) on the full outer transparent conductive oxide layer structure (9),
forming a mask of resist on the metal seed layer covering only the separated later non-contact areas of the interdigitated n- and p-type contacts (11, 11'),
forming contact fingers by depositing metal in the regions being free of resist by electrochemical plating,
stripping the resist, and
etching back chemically the material of the outer transparent conductive oxide layer (9) between the contact fingers.

10. Method of at least one of the claims 4 to 9, **characterized in that** the step of forming the interdigitated n- and p-type contacts (11, 11') comprises further the step of:
melting the material of the recombination layer structure and the outer transparent conductive oxide layer (9) through the intermediate second type doped semiconductor layer structure (8) by laser scribing.
